**Europäisches Patentamt**

**European Patent Office**

**Office européen des brevets**

(11) Veröffentlichungsnummer: **0 464 394 A2**

## EUROPÄISCHE PATENTANMELDUNG

(21) Anmeldenummer: **91109316.9**

(22) Anmeldetag: **06.06.91**

(51) Int. Cl.5: **H01L 33/00**, H01L 25/075

(30) Priorität: **03.07.90 DE 4021128**

(43) Veröffentlichungstag der Anmeldung:
**08.01.92 Patentblatt 92/02**

(84) Benannte Vertragsstaaten:
**DE FR GB IT**

(71) Anmelder: **SIEMENS AKTIENGESELLSCHAFT
Wittelsbacherplatz 2
W-8000 München 2(DE)**

(72) Erfinder: **Stein, Karl-Ulrich, Dr.
Isartalstrasse 14
W-8025 Unterhaching(DE)**

(54) **Verfahren zum Herstellen einer Leuchtdiodenanzeigevorrichtung.**

(57) Ein Verfahren zum Herstellen einer LED-Anzeigevorrichtung, bei dem eine Anzahl von LED-Chips (3) auf einem aus Leiterbahnen bestehenden Systemträger (1) angeordnet werden und die LED-Chips (3) einzeln jeweils in einen diesen zugeordneten, ein Lichtaustrittsfenster aufweisenden Lichtleitkanal (4) aus einem transparenten Kunststoff eingebettet werden, soll insbesondere die Realisierung schwallötfähiger, oberflächenmontierbarer LED-Displays ermöglichen. Der spezifisch gestaltete Systemträger (1) wird mit Dicht- und Stützstegen (2) ausgestattet und an den mit den LED-Chips (3) versehenen Stellen zum Bilden voneinander getrennter Lichtleitkanäle (4) mit einem diffus streuenden, transparenten Kunststoff umhüllt. Nach dessen Erstarren werden in einem ersten Freistanzprozeß die Dicht- und Stützstege (2) im Innern des Systemträgers (1) entfernt und dann die Lichtleitkanäle (4) und diese umgebende Innenbereiche des Systemträgers (1) mit einer reflektierenden Umhüllung (5) versehen.

Das erfindungsgemäße Verfahren findet bei der Herstellung von LED-Displays und LED-Symbolbeleuchtungen Anwendung.

FIG 2

EP 0 464 394 A2

Die Erfindung betrifft ein Verfahren zum Herstellen einer Leuchtdiodenanzeigevorrichtung, bei dem eine Anzahl von Leuchtdioden-Chips auf einem aus Leiterbahnen bestehenden Systemträger angeordnet und kontaktiert wird, und bei dem die Leuchtdioden-Chips einzeln jeweils in einen diesen zugeordneten, ein Lichtaustrittsfenster aufweisenden Lichtleitkanal aus einem diffus streuenden Kunststoff eingebettet werden.

Derartige Display-Anordungen sind bekannt und in der einschlägigen Literatur beschrieben. Als Systemträger für die Leuchtdioden(LED)-Chips wird dabei ein sogenannter Leadframe verwendet. Bei diesen Display-Anordnungen hat sich über die letzten Jahre ein Standard mit sog. Dual-In-Line-(DIL-)Anschlüssen etabliert, der allerdings die heute dominanten Anforderungen für oberflächenmontierbare Bauelemente nicht erfüllt. Die bekannten Displays sind insbesondere nicht ausreichend temperaturfest, um die bei der SMD-(Surface Mounted Device-)Technik geforderte Schwallötung zu überstehen. Zudem sind die elektrischen Anschlüsse nicht ohne weiteres SMD-fähig.

Lösungsansätze für dieses Problem sind nur durch den Ersatz der Einzelsegmente des Displays, z.B. durch einzelne SOT-23-LEDs, zu sehen. Derartige Möglichkeiten sind jedoch aufwendig und unrationell.

Der Erfindung liegt die Aufgabe zugrunde, ein Verfahren zum Herstellen einer Leuchtdiodenanzeigevorrichtung zu schaffen, das insbesondere die Realisierung schwallotfähiger, oberflächenmontierbarer LED-Displays ermöglicht.

Diese Aufgabe wird bei einem Verfahren der eingangs genannten Art erfindungsgemäß dadurch gelöst, daß der spezifisch gestaltete, flache Systemträger mit Dicht- und Stützstegen ausgestattet wird, daß der Systemträger an den mit den Leuchtdioden-Chips versehenen Stellen zum Bilden voneinander getrennter Lichtleitkanäle mit einem diffus streuenden, transparenten Kunststoff umhüllt wird, daß nach Erstarren des Kunststoffes in einem ersten Freistanzprozeß die Stütz- und Dichtstege im Inneren des Systemträgers entfernt werden, daß dann die Lichtleitkanäle und diese umgebende Innenbereiche des Systemträgers mit einer reflektierenden Umhüllung versehen werden, und daß abschließend Freistanz-, Biege- und Meßprozesse durchgeführt werden.

Vorzugsweise wird der Systemträger (Leadframe) an den mit den Leuchtdioden(LED)-Chips versehenen Stellen zum Bilden voneinander getrennter Lichtleitkanäle mit einer Diffusormaterial enthaltenden transparenten Spritzmasse umspritzt.

Gemäß einer vorteilhaften Ausgestaltung der Erfindung werden die Lichtleitkanäle nach dem Erstarren des Kunststoffes und die an diese angrenzenden Bereiche des Systemträgers mit einer hochreflektierenden weißen Masse als reflektierende Umhüllung umspritzt.

Gemäß einer Weiterbildung der Erfindung wird die reflektierende Umhüllung nach dem Verfestigen der Lichtleitkanäle auf deren Oberflächen und daran angrenzenden Teile des Systemträgers durch Tauchen oder Sprühen aufgebracht.

Der besondere Vorteil einer nach dem erfindungsgemäßen Verfahren hergestellten Anordnung besteht darin, daß die Displays SMD-fähig sind und in Streifen- oder in der sogenannten Reel-to-Reel-(Spule-zu-Spule-)Technik vom ersten Die-Bond bis zum Schlußmessen gehandhabt werden können. Dies erlaubt eine extrem kostengünstige Mechanisierung und stellt die Voraussetzung für eine DPM-Qualität bei der Herstellung dar. Die bei den heutigen Herstelltechniken vorliegenden Probleme, wie Belastung der Bonddrähte und Übersprechen zwischen den Segmenten, werden durch die Konstruktion vermieden.

Anhand von in den Figuren der Zeichnung schematisch dargestellten Ausführungsbeispielen wird die Erfindung näher erläutert.

Es zeigen

FIG 1 ein Kontaktierschema des vorgeschlagenen Displays,

FIG 2 ein Schema des Displays mit SMD-Anschlüssen,

FIG 3 ein Vorwärtsstrahler-Display-Segment im Schnitt,

FIG 4 das Segment nach FIG 3 in Draufsicht und

FIG 5 ein Rückwärtsstrahler-Display-Segment.

Ein schwallötfähiges SMD-Display wird erfindungsgemäß in folgenden Verfahrensschritten hergestellt:

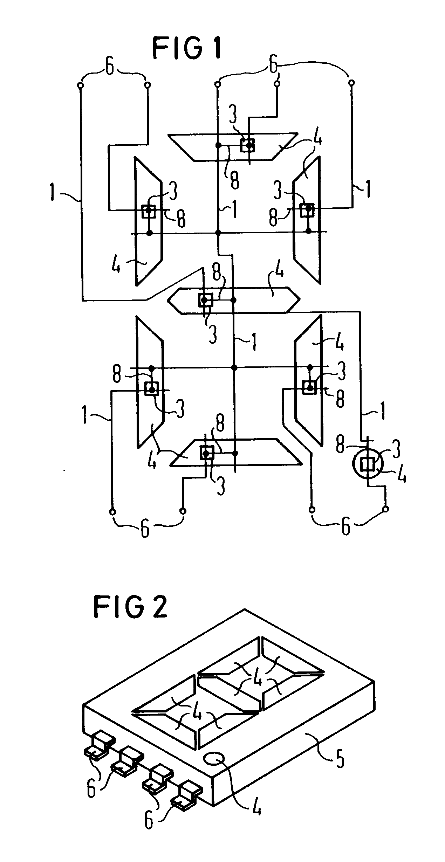

Als Systemträger 1 für das gesamte Display wird ein spezifisch gestaltetes, flaches Leadframe verwendet, das in ausreichendem Umfang mit Dicht- und Stützstegen ausgestattet wird. Auf diesem Systemträger (Leadframe) 1 werden im üblichen Die-Wire-Bond-Verfahren die einzelnen LED-Chips 3 aufgebracht. Im folgenden Schritt wird der mit den LED-Chips 3 versehene Systemträger (Leadframe) 1 mit den lichttransparenten Lichtleitkanälen 4 für die einzelnen Segmente umspritzt. Ein Beispiel für das Kontaktierschema ist in FIG 1 dargestellt. Diese Lichtleitkanäle 4 haben untereinander keine Verbindung. Zur mechanischen Versteifung weisen sie zweckmäßig nur zusätzliche Stützelemente zum Systemträger (Leadframe) 1 auf. Die Lichtleitkanäle 4 bestehen aus einer transparenten Spritzmasse, die mit etwas Diffusormaterial versetzt wird. Die Lichtleitkanäle 4 umhüllen den Systemträger 1 vollständig und werden in an sich bekannter Weise hergestellt. In einem anschließenden Schritt werden in einem ersten Freistanzprozeß die Stütz- und

Dichtstege im Inneren des Displays entfernt. In einem weiteren Verfahrensschritt werden die Lichtleitkanäle 4 und Teile des Systemträgers (Leadframe) 1 mit einer hochreflektierenden weißen Masse (Umhüllung 5) umspritzt. Offen bleiben nur die elektrischen Anschlüsse 6 samt Dichtstegen und die Lichtaustrittsfenster der Segmente bzw. Lichtleitkanäle 4. Abschließend erfolgen Freistanz-, Biege- und Meßprozesse sowie nötigenfalls ein Bearbeiten (z.B. Abfräsen) der Oberfläche, so daß dann das als Beispiel in FIG 2 dargestellte Display mit SMD-fähigen Anschlüssen 6 vorliegt.

Als Alternative zur zweiten Umspritzung (double-mould) mit einem weißen Reflektormaterial werden Systemträger (Leadframe) 1 und erste Umspritzung mit transparentem Material, d.h. die auf diese Weise hergestellten Lichtleitkanäle 4 so stabil ausgeführt, daß nur noch eine reflektierende Oberfläche, z.B. durch Tauchen oder Sprühen, an den betreffenden Flächen aufgebracht wird.

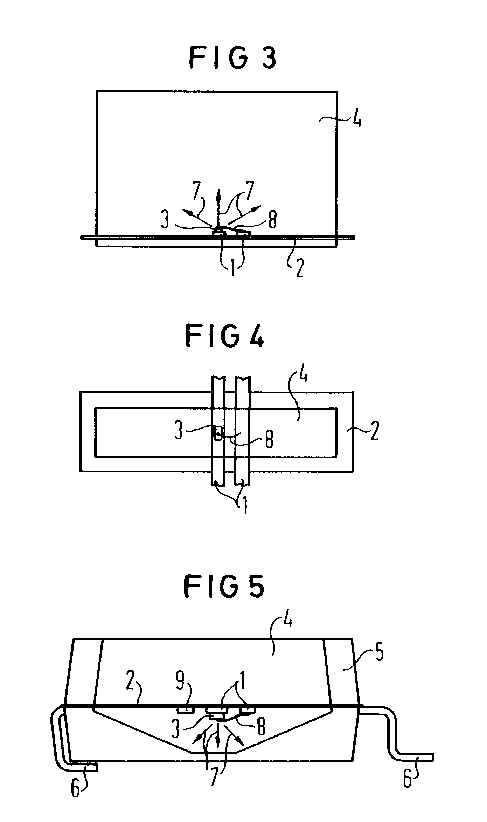

Die als leuchtende Segmente dienenden Lichtleitkanäle 4 können mit vorwärts, d.h. zur Oberfläche (Lichtaustrittsfenster) strahlenden LED-Chips 3 gestaltet werden. Ein solches Display-Segment ist in FIG 3 in Seitenansicht und in FIG 4 in Draufsicht dargestellt. Die Lichtausbreitungsrichtung des von dem LED-Chip 3 herrührenden Lichtes ist mit Pfeilen 7 angedeutet. Ein in diesem Beispiel dargestellter Dicht- bzw. Stützsteg 2 verläuft quer zu den beiden Leiterbahnen des Systemträgers 1. Der LED-Chip 3 ist auf der einen Leiterbahn angeordnet und kontaktiert. Die andere Leiterbahn bildet über einem Verbindungsdraht (Die-Bond) 8 den zweiten elektrischen Anschluß für die Leuchtdiode 3. Mit dieser Anordnung ist eine den heutigen Displays ähnliche Bauhöhe bei vergleichbarem Diffusorgehalt zu erzielen.

Als weitere Version ist vorgesehen, daß die LED-Chips 3 rückwärts strahlen. Damit ist eine geringere Bauhöhe - vergleichbar dem für integrierte Schaltungen üblichen SOJ-Gehäuse - bei geringem Diffusorgehalt zu erreichen. Ein solches Display-Segment ist in FIG 5 dargestellt. Der in FIG 5 dargestellte linke elektrische Anschluß (Kontakt) 6 weist dabei die Gestalt eines J-Beinchens auf. Die Teile des Leadframes (Systemträger 1), die als Chipträger bzw. Kontaktiersteg das Lichtleitsegment (Lichtleitkanal 4) beidseitig durchstoßen, werden zur Erzielung einer gleichmäßigen Segmentausleuchtung, insbesondere beim Rückwärtsstrahler so schmal wie möglich und ggf. als symmetrische Dreier-Anordnung mit einem Blindsteg 9 ausgelegt. Der Blindsteg 9 kann zudem als zusätzliches Stützelement auch noch zur mechanischen Versteifung des Lichtleitkanals 4 beitragen. Wird das Prinzip, insbesondere des Rückwärtsstrahlers, geeignet abgewandelt, so kann damit ein einzelnes leuchtendes Segment oder eine Leuchtfläche für Oberflächenmontage gestaltet werden.

**Patentansprüche**

1. Verfahren zum Herstellen einer Leuchtdiodenanzeigevorrichtung, bei dem eine Anzahl von Leuchtdioden-Chips auf einem aus Leiterbahnen bestehenden Systemträger angeordnet und kontaktiert wird, und bei dem die Leuchtdioden-Chips einzeln jeweils in einen diesen zugeordneten, ein Lichtaustrittsfenster aufweisenden Lichtleitkanal aus einem lichttransparenten Kunststoff eingebettet werden, **dadurch gekennzeichnet,** daß der speziell gestaltete, flache Systemträger (1) mit Dicht- und Stützstegen (2) ausgestattet wird, daß der Systemträger (1) an den mit den Leuchtdioden-Chips (3) versehenen Stellen zum Bilden voneinander getrennter Lichtleitkanäle (4) mit einem diffus streuenden, transparenten Kunststoff umhüllt wird, daß nach Erstarren des Kunststoffes in einem ersten Freistanzprozeß die Stütz- und Dichtstege (2) im Innern des Systemträgers (1) entfernt werden, daß dann die Lichtleitkanäle (4) und diese umgebende Innenbereiche des Systemträgers (1) mit einer reflektierenden Umhüllung (5) versehen werden, und daß abschließend Freistanz-, Biege und Meßprozesse durchgeführt werden.

2. Verfahren nach Anspruch 1, **dadurch gekennzeichnet,** daß der Systemträger (1) an den mit den Leuchtdioden-Chips (3) versehenen Stellen zum Bilden voneinander getrennter Lichtleitkanäle (4) mit einer Diffusormaterial enthaltenden transparenten Spritzmasse umspritzt wird.

3. Verfahren nach Anspruch 1 oder 2, **dadurch gekennzeichnet,** daß die Lichtleitkanäle (4) nach dem Erstarren des Kunststoffes und die an diese angrenzenden Bereiche des Systemträgers (1) mit einer hochreflektierenden weißen Masse als reflektierende Umhüllung (5) umspritzt werden.

4. Verfahren nach Anspruch 1 oder 2, **dadurch gekennzeichnet,** daß nach dem Verfestigen der Lichtleitkanäle (4) auf deren Oberflächen und daran angrenzenden Teile des Systemträgers (1) durch Tauchen oder Sprühen die reflektierende Umhüllung (5) aufgebracht wird.

5. Verfahren nach einem der Ansprüche 1 bis 4, **dadurch gekennzeichnet,** daß die Lichtleitkanäle (4) zur mechanischen Versteifung mit zusätzlichen Stützelementen (9) zum Systemträger (1) versehen werden.

# FIG 1

# FIG 2

# FIG 3

# FIG 4

# FIG 5